# FASCICULE DE BREVET EUROPEEN

(11) **EP 0 599 739 B1**
(45) Date de publication et mention de la délivrance du brevet: **22.12.1999**
(21) Numéro de dépôt: 93420413.2
(22) Date de dépôt: 25.10.1993
(51) Int. Cl.: H01L 29/74, H01L 29/41, H01L 29/10, H01L 27/102

(54) **Thyristor et assemblage de thyristors à cathode commune**
Thyristor und Aufbau von Thyristoren mit gemeinsamer Katode
Thyristor and assembly of thyristors with common cathode

(30) Priorité: 29.10.1992 FR 9213340
(43) Date de publication de la demande: 01.06.1994
(73) Titulaire: STMicroelectronics S.A., 94250 Gentilly (FR)
(72) Inventeur: Pezzani, Robert, F-37210 Vouvray (FR)
(74) Mandataire: de Beaumont, Michel

(56) Documents cités:
- GB-A- 1 580 490
- US-A- 4 163 241

## Description

La présente invention concerne une structure de thyristor et un mode d'assemblage monolithique de thyristors à cathodes et gâchettes communes, les gâchettes étant référencées par rapport aux cathodes.

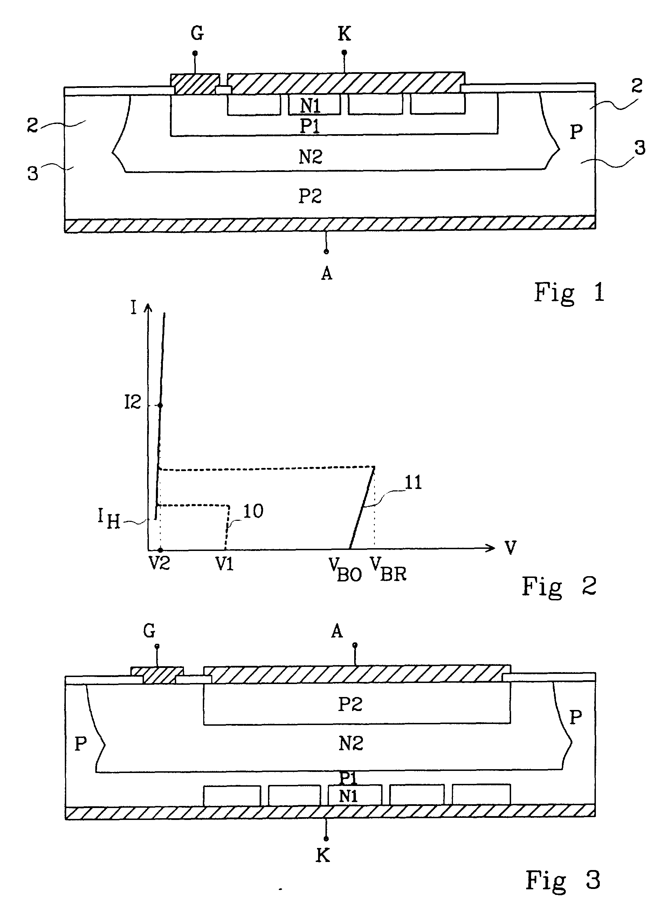

La figure 1 représente une structure très classique de thyristor. Cette structure est formée à partir d'un substrat N2 de type N d'une épaisseur de plusieurs centaines de microns. Du côté inférieur du substrat est formée uniformément une couche P (P2) qui correspond à l'anode du thyristor revêtue d'une métallisation d'anode A. Du côté de la face supérieure est formée une région P1 de type P correspondant à une couche de gâchette de cathode dans laquelle est formée une région de cathode N1 de type N. Une métallisation G est solidaire de la région de gâchette et une métallisation K est formée sur la région N1 et forme l'électrode de cathode. De façon classique, on a représenté des interruptions de la région N1, qui correspondent à des courts-circuits d'émetteur.

A la périphérie du thyristor sont formées à partir des faces supérieure et inférieure des diffusions P 2 et 3 qui se rejoignent pour fournir ce que l'on appelle habituellement une structure de thyristor à caisson.

Avec une telle structure, c'est la face d'anode qui peut être montée sur un radiateur et qui correspond au côté de refroidissement du thyristor et aussi, en général (sauf montage à isolement), au potentiel du radiateur. Avec une telle structure, il est facile de réaliser de façon intégrée plusieurs thyristors en parallèle à anodes communes.

Dans ces thyristors, la gâchette est référencée par rapport à la cathode, c'est-à-dire que le thyristor devient conducteur si, tandis que son anode est positive par rapport à sa cathode, une tension positive est appliquée entre gâchette et cathode pour faire circuler un courant de la gâchette vers la cathode.

Les constructeurs de thyristors ont depuis longtemps optimisé les niveaux de dopage et les formes en vue de dessus des diverses couches ainsi que l'allure des trous de courts-circuits pour optimiser les divers paramètres souhaités d'un tel thyristor à gâchette de cathode, c'est-à-dire notamment sa tenue en tension et ses paramètres de commutation à l'ouverture et à la fermeture.

La figure 2 illustre certains de ces paramètres.
- Si la tension entre anode et cathode est une tension positive égale à V1 et si une tension de gâchette est appliquée, comme le représente la courbe 10, le courant entre anode et cathode croit rapidement puis la tension chute à une valeur faible jusqu'à ce que la tension et le courant s'établissent à des valeurs V2, I2 correspondant aux paramètres du circuit dans lequel est inséré le thyristor. Ensuite, le thyristor reste dans cet état même si le courant de gâchette est interrompu. On dira que le thyristor est sensible à la fermeture s'il suffit d'une faible tension gâchette-cathode et d'une faible circulation de courant de gâchette pour entraîner la mise en conduction.
- Pour ouvrir le thyristor, il faut que la tension à ses bornes décroisse jusqu'à ce que le courant qui le traverse devienne inférieur à un courant de maintien IH.
- Par ailleurs, le thyristor présente une certaine tenue en tension directe. C'est-à-dire que si, en l'absence de courant de gâchette, la tension dépasse une valeur de seuil V_{BR}, le thyristor claque et la caractéristique tension-courant correspond à la courbe 11. En outre, cette valeur de claquage du thyristor dépend de la rapidité de la montée en tension, c'est ce qu'on appelle la caractéristique de tenue en dV/dt du thyristor.

Parmi les paramètres caractéristiques d'un thyristor, on se soucie également essentiellement de ces paramètres de sensibilité, de tenue en dV/dt et de courant de maintien. Or, ces divers paramètres sont antinomiques. En particulier, en diminuant le taux de courts-circuits d'émetteur, on augmente la sensibilité à la fermeture, alors qu'en augmentant ce taux on réduit les problèmes liés aux déclenchements en dV/dt et on augmente IH.

Néanmoins, dans le cadre des structures de thyristors à anode commune et à gâchette référencée à la cathode du type de ceux illustrés en figure 1, on est arrivé à optimiser l'ensemble de ces paramètres de façon satisfaisante. Il est d'ailleurs connu que l'on peut augmenter encore la sensibilité à la fermeture, en prévoyant des structures de type darlistor ou thyristor à amplification de gâchette de cathode.

Dans certaines applications, on souhaite disposer de thyristors dans lesquels l'électrode de gâchette se trouve du coté de la métallisation d'anode de sorte que la métallisation de cathode soit seule sur une face du composant et puisse être montée directement sur un radiateur. On peut alors penser à des thyristors à gâchette d'anode. Toutefois, la réalisation de tels thyristors pose des problèmes mal résolus aujourd'hui.

En effet, contrairement à ce qui est généralement affirmé dans les brevets d'invention où l'on indique souvent, après avoir décrit un thyristor à gâchette de cathode qu'une structure équivalente pourrait être obtenue en intervertissant tous les types de conductivité des couches N et P, il n'y a pas équivalence entre une couche N et une couche P. Notamment, la mobilité des porteurs n'est pas la même dans une couche N et dans une couche P et il n'est pas possible d'obtenir de mêmes niveaux de dopage en type N et en type P. Par exemple, il est très difficile d'obtenir des niveaux de dopage très élevés en type P.

La solution qui consisterait à transformer le thyristor de la figure 1 en thyristor à gâchette d'anode en intervertissant tous les types de conductivité n'est pas satisfaisante notamment du fait qu'il ne serait pas possible de remplacer la couche N1 par une couche de type P à très fort niveau de dopage.

Une autre solution pour obtenir un thyristor à gâchette d'anode est illustrée en figure 3 dans laquelle la couche P1 de gâchette de cathode devient une couche P2 d'anode, le substrat N2 a maintenant une fonction de gâchette d'anode, la couche P1 devient une couche de gâchette de cathode (non connectée) et la couche N1 de cathode est formée du côté de la face inférieure. Ceci amène à une structure très peu sensible du fait que la gâchette est liée à une couche N2 très épaisse (le substrat) qui est la couche qui permet la tenue en tension.

Ainsi, dans la pratique, on trouve essentiellement des thyristors à gâchette de cathode tels que celui illustré en figure 1 et pratiquement pas de thyristors à gâchette d'anode. Ceci entraîne que l'on sait faire simplement des montages de thyristors où plusieurs thyristors sont montés en parallèle avec une anode commune, reliée à un dissipateur thermique mais qu'il est très difficile de faire des montages de thyristors en parallèle à cathode commune.

Un autre inconvénient des thyristors à gâchette d'anode est que, même si l'on savait en fabriquer de performants, ils ont de façon inhérente une gâchette référencée à leur anode alors que dans de nombreux montages électriques, on souhaite obtenir des thyristors dont le déclenchement est obtenu par une tension référencée à la cathode et non pas à l'anode. Un autre thyristor est décrit dans GB-A-1580490.

Ainsi, un premier objet de l'invention est de réaliser un thyristor dont la cathode corresponde à une première face principale d'une pastille semiconductrice (la face inférieure) et dont la gâchette se trouve sur la face portant l'anode, tandis que le déclenchement du thyristor s'effectue par une tension appliquée sur la gâchette et référencée par rapport à la cathode.

Un autre objet de la présente invention est de prévoir un tel thyristor qui soit sensible à la fermeture, qui présente une forte insensibilité aux déclenchements en dv/dt et qui puisse avoir un courant de maintien de valeur élevée.

Pour atteindre cet objet ainsi que d'autres, la présente invention prévoit un thyristor monolithique comprenant un thyristor vertical comportant en face avant une région d'anode localisée et en face arrière une métallisation de cathode recouvrant sensiblement toute cette face arrière, et, du côté de la face avant, un thyristor latéral, dont les régions d'anode et de gâchette d'anode correspondent aux régions d'anode et de gâchette d'anode du thyristor vertical. La gâchette du thyristor correspond à la cathode ou à la gâchette de cathode du thyristor latéral ; la région de gâchette de cathode ou la cathode, respectivement, du thyristor latéral est reliée à la cathode du thyristor vertical.

En d'autres termes, l'invention prévoit un thyristor comprenant un substrat de type N ; sur la face avant, une région d'anode de type P revêtue d'une métallisation d'anode ; sur la face arrière, une couche P, dans laquelle est formée une région N de cathode, cette face arrière étant revêtue d'une métallisation de cathode, l'ensemble de ces couches formant un thyristor vertical ; dans le substrat, du côté de la faoe avant, un caisson P dans lequel est formé une zone N, ce caisson et cette zone formant avec le substrat et la région d'anode un thyristor latéral ; une borne de gâchette reliée électriquement audit caisson P ou à ladite zone N ; et une liaison électrique entre la cathode et ladite zone N ou ledit caisson P, respectivement.

Selon un mode de réalisation de la présente invention, la région de cathode du thyristor vertical est munie de courts-circuits d'émetteur, et la région de cathode du thyristor latéral est exempte de courts-circuits d'émetteur.

Selon un mode de réalisation de la présente invention, une région périphérique de type P va de la face supérieure à la face inférieure du thyristor.

Selon un mode de réalisation de la présente invention, dans le cas d'une liaison entre la région de gâchette de cathode du thyristor latéral et la métallisation de cathode cette liaison est réalisée par une continuité entre ladite région de gâchette et ladite région périphérique.

Selon un mode de réalisation de la présente invention, dans le cas d'une liaison entre la région de cathode du thyristor latéral et la métallisation de cathode, cette liaison est assurée par une métallisation rejoignant la cathode du thyristor latéral et la surface supérieure de ladite région périphérique.

La présente invention prévoit aussi un assemblage de thyristors à gâchettes communes et cathodes communes constitué de la mise en parallèle de thyristors tels que définis ci-dessus, les cathodes de ces thyristors étant montées sur un même radiateur.

Selon un mode de réalisation de la présente invention, cet assemblage de thyristors à gâchettes communes et cathodes communes est réalisé sous forme monolithique. Plusieurs thyristors verticaux sont assemblés en parallèle dans un même substrat. Cet assemblage comprend des régions supplémentaires communes de gâchette de cathode et de cathode d'un thyristor latéral qui se continue par les régions de gâchette d'anode et d'anode de chacun des thyristors verticaux.

Ces objets, caractéristiques et avantages ainsi que d'autres de la présente invention seront exposés en détail dans la description suivante de modes de réalisation particuliers faite en relation avec les figures jointes parmi lesquelles :
les figures 1 à 3, qui rappellent l'état de la technique et présentent le problème posé, ont été décrites précédemment ;
la figure 4 est une vue en coupe d'un thyristor selon la présente invention ;
la figure 5A est une vue en coupe représentant un premier mode de connexion d'un thyristor selon la présente invention et les figures 5B et 5C sont des schémas équivalents ;
la figure 6A est une vue en coupe représentant un deuxième mode de connexion d'un thyristor selon la présente invention et les figures 6B et 6C sont des schémas équivalents ;
la figure 7 représente un exemple de réalisation du thyristor de la figure 5A ;
la figure 8 représente un exemple de réalisation du thyristor de la figure 6A ;
les figures 9A et 9B représentent des exemples de circuits à thyristors ; et
la figure 10 représente un mode de réalisation selon la présente invention d'un ensemble de deux thyristors en parallèle à cathode commune et à commande par gâchette de cathode.

Dans les diverses vues en coupe de composants semiconducteurs, on notera que les dimensions ne sont pas tracées à l'échelle et notamment que les épaisseurs et les dimensions latérales des couches sont arbitrairement dilatées ou rétrécies pour faciliter la lisibilité des figures et simplifier leur tracé.

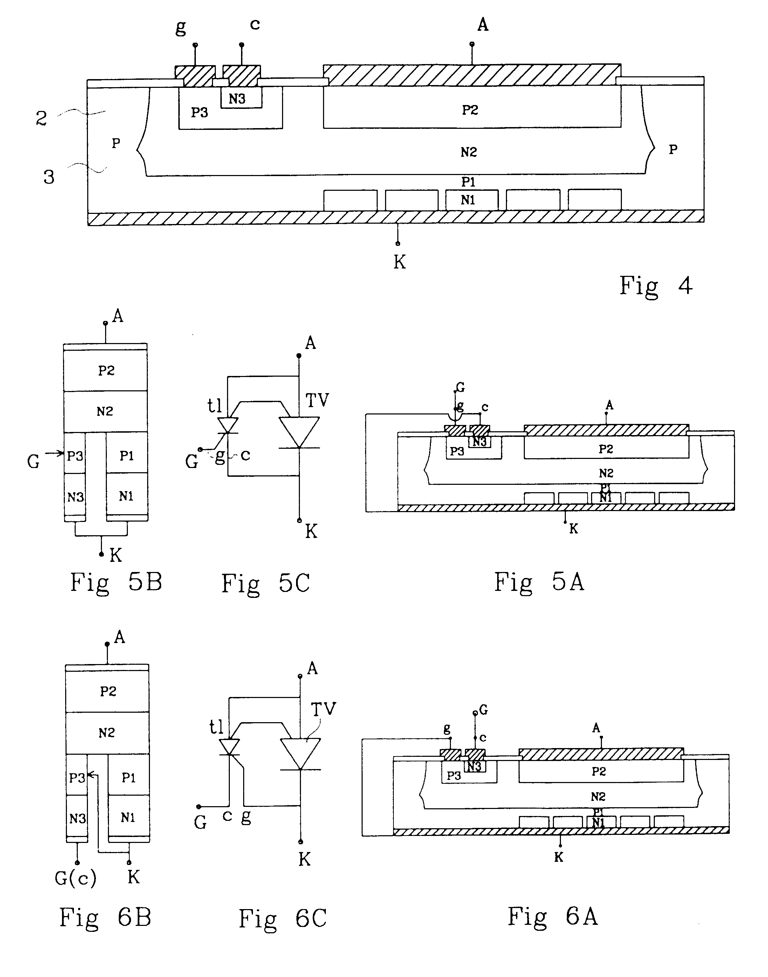

La figure 4 représente une vue en coupe d'un thyristor selon la présente invention. Ce thyristor est élaboré à partir d'un substrat N2 de type N dont la face arrière est revêtue d'une couche P1 de type P dans laquelle est formée une région N1 de cathode de type N qui peut, de façon classique, être interrompue pour former des régions de courts-circuits d'émetteur. La face arrière est revêtue sur sensiblement toute sa surface d'une métallisation de cathode. La région N1 est située en face d'une région P2 formée à partir de la face supérieure dans le substrat N2. La région P2 constitue l'anode d'un thyristor et est revêtue d'une métallisation d'anode A. En outre, dans la région N2, est formée un caisson P3 de type P à l'intérieur duquel est formée une région N3 de type N. Le caisson P3 est solidaire d'une métallisation g et la région N3 d'une métallisation c.

Ainsi, le thyristor de la figure 4 présente en face arrière une métallisation unique de cathode et c'est sur la face avant que se trouvent une métallisation d'anode et des métallisations supplémentaires g et c.

On reconnaît dans cette figure un thyristor vertical TV comprenant des couches P2, N2, P1, N1 et un thyristor latéral tl, du côté de la face avant, comprenant les couches N3, P3, N2, P2. La région N1 est classiquement munie de courts-circuits d'émetteur pour que le thyristor principal présente un IH élevé et une forte insensibilité aux déclenchements en dV/dt. Par contre, la région N3 n'est pas munie de courts-circuits d'émetteur pour que le thyristor latéral soit sensible à la fermeture.

Il sera clair pour l'homme de métier que les plus grandes parties des surfaces supérieure et inférieure du composant sont respectivement occupées par les régions P2 et N1.

La structure de la figure 4 est susceptible de deux modes de montage.

Dans un premier mode de montage illustré en figure 5A, la borne c est reliée à la borne K et la borne g constitue la borne de gâchette G du composant.

Le fonctionnement de ce premier mode de montage sera exposé en relation avec le schéma équivalent sous forme de couches de la figure 5B ou au schéma équivalent sous forme de circuit de la figure 5C. Le thyristor latéral P2-N2-P3-N3 et le thyristor vertical P2-N2-P1-N1 ont en commun leurs couches d'anode et de gâchette d'anode. Leurs cathodes N3 et N1 sont connectées. Ainsi, quand la tension entre les bornes A et K est positive et qu'un signal est appliqué sur la borne G, le thyristor latéral P2-N2-P3-N3 devient passant entre les bornes A et K. Immédiatement après, étant donné qu'il circule un courant entre les régions P2-N2, le thyristor vertical P2-N2-P1-N1 devient également passant. On peut assimiler son déclenchement à un déclenchement par un courant de gâchette d'anode. Dès que le thyristor vertical devient passant, étant donné qu'il est en parallèle sur le thyristor latéral, que sa surface est beaucoup plus grande et que sa résistance à l'état passant est beaucoup plus faible, c'est ce thyristor vertical qui reste conducteur et le thyristor latéral se rebloque, le courant qui le traverse devenant inférieur à son courant de maintien.

En résumé, la structure d'ensemble vue des bornes A, K et G (g) fonctionne comme un thyristor à gâchette de cathode dans lequel le déclenchement est obtenu par application d'une tension de gâchette positive par rapport à la tension de cathode. Un avantage de cette structure, outre le fait qu'elle permet des montages à cathode sur radiateur, est que les paramètres de fermeture, c'est-à-dire de sensibilité au courant de gâchette sont liés au thyristor latéral tl alors que les paramètres à l'ouverture ou au déclenchement parasite (IH et sensibilité en dV/dt) sont liés à la structure du thyristor vertical TV. Il est donc possible d'optimiser indépendamment ces divers paramètres.

Dans un deuxième mode de montage illustré en figure 6A, la borne g est reliée à la borne K et la borne c constitue la borne de gâchette G du composant.

Le fonctionnement de ce deuxième mode de montage sera exposé en relation avec le schéma équivalent sous forme de couches de la figure 6B ou au schéma équivalent sous forme de circuit de la figure 6C. Le thyristor latéral P2-N2-P3-N3 et le thyristor vertical P2-N2-P1-N1 ont en commun leurs couches d'anode et de gâchette d'anode. La couche de gâchette de cathode du transistor latéral est reliée à la cathode K du thyristor vertical. Le thyristor latéral tl se déclenche si son anode est positive par rapport à sa cathode et si la tension sur la borne G (ou c) est négative par rapport à la tension sur la borne K. Ensuite, comme précédemment, le thyristor vertical TV s'amorce et le thyristor latéral tl se bloque.

On obtient donc à nouveau une structure fonctionnant comme un thyristor à gâchette de cathode mais dans laquelle le déclenchement est produit quand la gâchette est négative par rapport à la cathode. De plus, comme précédemment, il y a séparation entre les paramètres de mise en conduction et les paramètres d'ouverture et de déclenchement parasite.

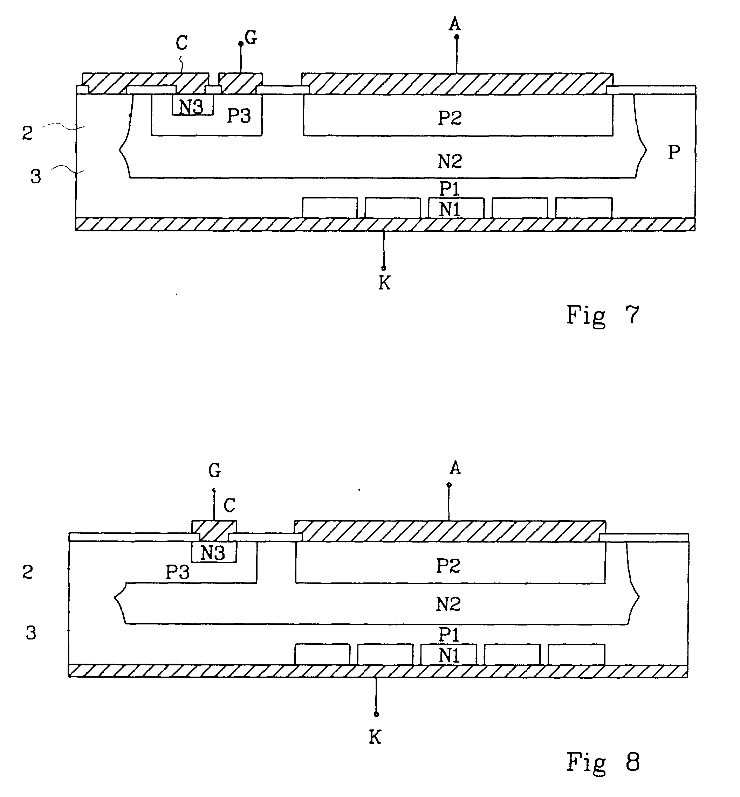

En pratique, le composant selon la présente invention peut être réalisé de diverses façons, notamment en ce qui concerne la connexion entre la borne g ou c et la borne de cathode (la face arrière).
- Le composant de la figure 4 peut être placé dans un boîtier, les quatre bornes A, K, g et c étant accessibles et l'utilisateur choisissant de connecter de façon externe la borne g ou c à la borne K. Cette solution est tout à fait envisageable car, en cas de mauvais montage, il ne se produira pas de risque d'accident ou de destruction. Tout simplement, si l'utilisateur applique une tension de gâchette positive en cas de connexion de la borne g à la borne K ou une tension négative en cas de connexion de la borne c à la borne K, le composant ne fonctionnera pas et il suffira de modifier la polarité de la tension de commande ou d'inverser les connexions.
- La connexion peut être faite à l'intérieur du boîtier par un conducteur métallique, par exemple un fil d'aluminium.
- La connexion peut être réalisée de façon intégrée comme cela est illustré en figures 7 et 8.

La figure 7 correspond à un mode de réalisation intégré du montage de la figure 5A. Dans ce mode de réalisation, la métallisation de cathode c du thyristor latéral tl s'étend jusqu'à entrer en contact avec la diffusion latérale de type P (2-3) rejoignant la couche P1 de face arrière. Dans ce mode de réalisation la métallisation c n'est pas reliée à une borne externe.

La figure 8 correspond à un mode de réalisation intégré du montage de la figure 6A. Dans ce mode de réalisation, la région P3 s'étend jusqu'à entrer en contact avec la diffusion latérale 2-3 rejoignant la face arrière et la métallisation c correspond à la borne G de commande du thyristor selon l'invention.

Bien entendu, les diverses vues en coupe des figures 4, 5A, 6A, 7 et 8 sont uniquement illustratives et, en fait, il n'y a pas nécessairement alignement dans un plan de coupe des métallisations c, g et A.

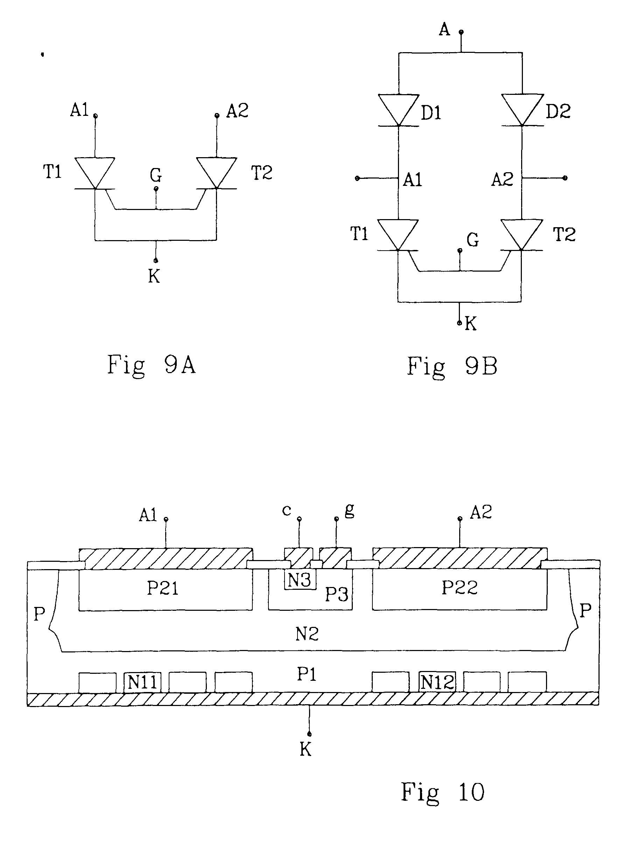

Bien que le thyristor selon la présente invention puisse être utilisé isolément avec les avantages indiqués précédemment, il trouve une application toute particulière à des montages dans lesquels deux thyristors (ou plus) sont connectés en cathodes et gâchettes communes. Un tel montage de deux thyristors T1, T2 à cathodes K et à gâchettes G communes est illustré en figure 9A. Ces thyristors ont des anodes respectivement désignées par A1 et A2. Ce montage se trouve par exemple dans certains ponts commandés tels qu'illustrés en figure 9B où une tension alternative est fournie entre les anodes A1 et A2. Ces anodes sont reliées à une première borne de tension continue A par l'intermédiaire de diodes respectives D1 et D2 et la borne K constitue une deuxième borne de tension continue. On a représenté en figure 9B un montage monophasé, on pourrait de même rajouter une branche pour constituer un montage triphasé.

Pour réaliser les thyristors T1 et T2 à cathodes communes montées sur un même radiateur on pourrait utiliser deux thyristors selon la présente invention en parallèle. Il est aussi possible comme le représente la figure 10 de réaliser une structure intégrée dans laquelle on reconnaît à droite et à gauche des structures de thyristor vertical, respectivement P21-N2-P1-N11 et P22-N2-P1-N12, similaires à celle de la figure 4 et dans la partie centrale les régions supplémentaires N3 et P3. La borne c ou la borne g pourra être reliée à la borne K selon que l'on souhaite réaliser une commande par tension de gâchette négative ou positive par rapport à la cathode. Ainsi, quand une tension de commande est appliquée, celui des thyristors T1 et T2 dont l'anode est positive par rapport à la cathode deviendra conducteur.

L'homme de métier saura choisir pour chacune des structures des figures 4, 5A, 6A, 7, 8 et 10 des topographies de couches et des niveaux de dopage convenables en utilisant les règles classiques de conception de thyristors. A titre de rappel, on notera que les niveaux de dopage des diverses couches peuvent par exemple être :

| | |
|---|---|
| couche N2 | 5.10¹³ à 10¹⁵ atomes/cm³, |
| couche P1, régions P2 et P3 | 10¹⁷ à 10¹⁹ atomes/cm³, |
| régions N1 et N3 | 10²⁰ à 10²¹ atomes/cm³. |

Bien que cela simplifie la réalisation, les niveaux de dopage des couches et régions P1, P2 et P3 ne sont pas nécessairement identiques et peuvent être choisis différents pour optimiser certaines caractéristiques de fonctionnement du thyristor.

Dans la présente description, on a présenté la structure selon l'invention comme formée à partir d'un substrat N épais (quelques centaines de micromètres) dans lequel sont formées par diffusion ou implantation les autres couches ou régions. Néanmoins, tout mode de fabrication connu de thyristors pourra être utilisé. On pourra par exemple partir d'un substrat de type P correspondant à la région P1 sur lequel la couche N2 est amenée à croître par épitaxie.

Par ailleurs, on a illustré dans toutes les figures, une structure du type thyristor à caisson. La présente invention pourrait également s'appliquer à d'autres structures de thyristor, par exemple des structures mésa ou planar.

## Revendications

1. Thyristor monolithique comprenant un thyristor vertical (TV) comportant en faoe avant une région d'anode localisée (P2) et en face arrière une métallisation de cathode (K) recouvrant sensiblement toute cette face arrière, caractérisé en ce que :
il comprend en outre du côté de la face avant un thyristor latéral (tl), dont les régions d'anode et de gâchette d'anode correspondent aux régions d'anode et de gâchette d'anode du thyristor vertical,
la gâchette du thyristor correspond à la cathode (c) ou à la gâchette de cathode (g) du thyristor latéral, et
la gâchette de cathode (g) ou la cathode (c), respectivement, du thyristor latéral est reliée à la cathode du thyristor vertical.

2. Thyristor selon la revendication 1 comprenant :
un substrat de type N (N2) ;
sur la face avant, une région d'anode de type P (P2) revêtue d'une métallisation d'anode ;
sur la face arrière, une couche P (P1), dans laquelle est formée une région N (N1) de cathode, cette face arrière étant revêtue d'une métallisation de cathode, l'ensemble de ces couches formant un thyristor vertical (TV) ;
caractérisé en ce qu'il comprend en outre :
dans le substrat, du côté de la face avant, un caisson P (P3) dans lequel est formé une zone N (N3), ce caisson et cette zone formant avec le substrat (N2) et la région d'anode (P2) un thyristor latéral (tl) ;
une borne de gâchette (G) reliée électriquement audit caisson P ou à ladite zone N ; et
une liaison électrique entre la cathode et ladite zone N ou ledit caisson P, respectivement.

3. Thyristor selon la revendication 1 ou 2, caractérisé en ce que la région de cathode (N1) du thyristor vertical (TV) est munie de courts-circuits d'émetteur, et en ce que la région de cathode (N3) du thyristor latéral est exempte de courts-circuits d'émetteur.

4. Thyristor selon l'une quelconque des revendications 1 à 3, caractérisé en ce qu'il comprend une région périphérique de type P (2, 3), allant de sa face supérieure à sa face inférieure.

5. Thyristor selon la revendication 4, comprenant une liaison entre la région de gâchette de cathode (P3) du thyristor latéral et la métallisation de cathode, caractérisé en ce que ladite liaison est réalisée par une continuité entre ladite région de gâchette (P3) et ladite région périphérique.

6. Thyristor selon la revendication 4, comprenant une liaison entre la région de cathode (N3) du thyristor latéral et la métallisation de cathode, caractérisé en ce que ladite liaison est assurée par une métallisation rejoignant la cathode du thyristor latéral et la surface supérieure de ladite région périphérique.

7. Assemblage de thyristors à gâchettes communes et cathodes communes, caractérisé en ce qu'il est constitué de la mise en parallèle de thyristors selon l'une quelconque des revendications 1 à 6, les cathodes de ces thyristors étant montées sur un même radiateur.

8. Assemblage de thyristors à gâchettes communes et cathodes communes réalisé sous forme monolithique, caractérisé en ce que plusieurs thyristors verticaux selon l'une quelconque des revendications 1 à 6 sont assemblés en parallèle dans un même substrat et en ce qu'il comprend des régions supplémentaires communes de gâchette de cathode et de cathode d'un thyristor latéral qui se continue par les régions de gâchette d'anode et d'anode de chacun des thyristors verticaux.

## Patentansprüche

1. Monolitische Thyristor, welcher einen Vertikalthyristor (TV) umfaßt, der auf der Vorderseite einen lokalisierten Anodenbereich (P2) und auf der Rückseite eine Kathodenmetallisierung (K) aufweist, welche im wesentlichen diese gesamte Rückseite bedeckt, dadurch gekennzeichnet, daß:
- der Thyristor des weiteren an der Vorderseite einen Lateralthyristor (tl) aufweist, dessen Anodenbereich und Anoden-Gate-Bereich dem Anodenbereich und dem Anoden-Gate-Bereich des Vertikalthyristors entsprechen,
- das Gate des Thyristors der Kathode (c) oder dem Kathoden-Gate (g) des Lateralthyristors entspricht, und
- das Kathoden-Gate (g) bzw. die Kathode (c) des Lateralthyristors mit der Kathode des Vertikalthyristors verbunden ist.

2. Thyristor nach Anspruch 1, welcher umfaßt:
- ein N-Substrat (N2);
- auf der Vorderseite einen mit einer Anodenmetallisierung überzogenen Anodenbereich vom P-Typ (P2);
- auf der Rückseite eine P-Schicht (P1), in welcher ein N-Kathodenbereich (N1) ausgebildet ist, wobei diese Rückseite mit einer Kathodenmetallisierung überzogen ist und diese Schichten insgesamt einen Vertikalthyristor (TV) bilden;
dadurch gekennzeichnet, daß der Thyristor des weiteren umfaßt:
- in dem Substrat an der Vorderseite einen P-Graben bzw. -Schacht (P3), in welchem eine N-Zone (N3) ausgebildet ist, wobei dieser Graben bzw. Schacht und diese Zone mit dem Substrat (N2) und dem Anodenbereich (P2) einen Lateralthyristor (tl) bilden;
- einen elektrisch mit dem genannten P-Graben bzw. -Schacht oder mit der genannten N-Zone verbundenen Gate-Anschluß (G); sowie
- eine elektrische Verbindung zwischen der Kathode und der genannten N-Zone bzw. dem genannten P-Graben bzw. -Schacht.

3. Thyristor nach Anspruch 1 oder 2,
dadurch gekennzeichnet, daß der Kathodenbereich (N1) des Vertikalthyristors (TV) mit Emitter-Kurzschlüssen versehen ist und daß der Kathodenbereich (N3) des Lateralthyristors frei von Emitter-Kurzschlüssen ist.

4. Thyristor nach einem der Ansprüche 1 bis 3,
dadurch gekennzeichnet, daß er einen Umfangsbereich vom P-Typ (2, 3) aufweist, der sich von seiner Ober- bzw. Vorderseite bis zu seiner Rück- bzw. Unterseite erstreckt.

5. Thyristor nach Anspruch 4, mit einer Verbindung zwischen dem Kathoden-Gate-Bereich (P3) des Lateralthyristors und der Kathodenmetallisierung,
dadurch gekennzeichnet, daß die genannte Verbindung durch eine Kontinuität zwischen dem genannten Gate-Bereich (P3) und dem genannten Umfangsbereich gebildet wird.

6. Thyristor nach Anspruch 4, mit einer Verbindung zwischen dem Kathodenbereich (N3) des Lateralthyristors und der Kathodenmetallisierung,
dadurch gekennzeichnet, daß die genannte Verbindung durch eine die Kathode des Lateralthyristors und die Oberseite des genannten Umfangsbereichs verbindende Metallisierung gewährleistet wird.

7. Thyristoranordnung mit gemeinsamen Gates und gemeinsamen Kathoden,
dadurch gekennzeichnet, daß sie aus einer Parallelanordnung von Thyristoren gemäß einem der Ansprüche 1 bis 6 besteht, wobei die Kathoden dieser Thyristoren auf ein und demselben Kühlkörper montiert sind.

8. Thyristoranordnung mit gemeinsamen Gates und gemeinsamen Kathoden in monolithischer Ausbildung,
dadurch gekennzeichnet, daß die mehreren Vertikalthyristoren gemäß einem der Ansprüche 1 bis 6 in ein und demselben Substrat parallel zueinander angeordnet sind und daß die Anordnung zusätzliche gemeinsame Kathoden-Gate-Bereiche und Kathodenbereiche eines Lateralthyristors umfaßt, die sich jeweils in die Anoden-Gate-Bereiche und Anodenbereiche jedes der Vertikalthyristoren fortsetzen.

## Claims

1. A monolithic thyristor comprising a vertical thyristor (TV) including, on the front surface, a localized anode region (P2), and, on the rear surface, a cathode metallization (K) substantially coating the whole rear surface, characterized in that:
it further comprises, on the front surface side a lateral thyristor (tl), whose anode and anode gate regions correspond to the anode and anode gate regions of the vertical thyristor,
the gate of the thyristor corresponds to the cathode region (c) or to the cathode-gate region (g) of the lateral thyristor, and
the cathode-gate (g) or the cathode (c), respectively, of said lateral thyristor is connected to the cathode of the vertical thyristor.

2. A thyristor according to claim 1, including:
an N-type substrate (N2);
on the front surface, a P-type anode region (P2) coated with an anode metallization;
on the rear surface, a P-type layer (P1), in which is formed an N-type cathode region (N1), said rear surface being coated with a cathode metallization, the assembly of the above layers forming a vertical thyristor (TV) ;
characterized in that it further comprises:
in the substrate, on the front surface side, a P-type well (P3) in which is formed an N-type area (N3), said well and area forming with the substrate (N2) and the anode region (P2) a lateral thyristor (tl);
a gate terminal (G) electrically connected to said P-well or to said N-area; and
an electric connection between the cathode and said N-area or said P-well, respectively.

3. The thyristor of claim 1 or 2, characterized in that said cathode region (N1) of the vertical thyristor (TV) is provided with emitter shorts, and the cathode region (N3) of the lateral thyristor is free of emitter shorts.

4. The thyristor of any of claims 1 to 3, characterized in that it comprises a P-type peripheral region (2, 3) extending from the upper surface to the lower surface.

5. The thyristor of claim 4, comprising a connection between the cathode-gate region (P3) of the lateral thyristor and the cathode metallization, characterized in that said connection is formed by a continuous region between said gate region (P3) and said peripheral region.

6. The thyristor of claim 4, comprising a connection between the cathode region (N3) of the lateral thyristor and the cathode metallization, characterized in that said connection is made by a metallization bridging the cathode of the lateral thyristor and the upper surface of said peripheral region.

7. An assembly of thyristors having common gates and common cathodes, characterized in that it comprises the parallel connection of thyristors of any of claims 1 to 6, the cathodes of said thyristors being mounted on a same heat sink.

8. A monolithic assembly of thyristors having common gates and common cathodes, characterized in that several vertical thyristors of any of claims 1 to 6 are assembled in parallel in a same substrate, further comprising an additional common cathode-gate region and an additional common cathode region of a lateral thyristor that are prolonged by the anode-gate region and anode region of each vertical thyristor.
